# EUROPÄISCHE PATENTSCHRIFT

(11) **EP 1 398 640 B1**
(45) Veröffentlichungstag und Bekanntmachung des Hinweises auf die Patenterteilung: **09.09.2009**
(21) Anmeldenummer: 03016279.6
(22) Anmeldetag: 11.06.1999
(51) Int. Cl.: G01R 31/317, G01R 31/316

(54) **Einrichtung zur Vermessung und Analyse von elektrischen Signalen eines integrierten Schaltungsbausteins**
Device for measuring and analyzing electrical signals of an integrated circuit component
Dispositif pour mésurer et analyser des signaux électriques d'un circuit integré

(30) Priorität: 16.06.1998 DE 19826825
(43) Veröffentlichungstag der Anmeldung: 17.03.2004
(62) Teilanmeldung aus: 99938179.1
(73) Patentinhaber: Infineon Technologies AG, 85579 Neubiberg (DE)
(72) Erfinder: Schmid, Wilhelm, 85055 Ingolstadt (DE); Dörrhöfer, Carsten, 83607 Holzkirchen (DE)
(74) Vertreter: Repkow, Ines

(56) Entgegenhaltungen:
- EP-A- 0 650 069
- US-A- 5 712 858

## Beschreibung

Die Erfindung betrifft eine Einrichtung gemäß dem Oberbegriff des Anspruchs 1.

Um Fehlfunktionen und Taktkonzepte auf integrierten Schaltungsbausteinen analysieren zu können, ist es erforderlich, chipinterne Signale zu beobachten, also Signale, die an nicht zugänglichen Schaltungsstellen innerhalb des integrierten Schaltungsbausteins vorliegen. Dabei spielt sehr häufig eine zeitgenaue Signalbeobachtung eine wichtige Rolle. Dazu müssen beispielsweise Takte gegeneinander vermessen werden, asynchrone Signale wie Interrupts vermessen werden und Funktionen in Abhängigkeit von asynchronen Signalen analysiert werden.

Bei den bisherigen Analysen wurden spezielle, technisch äußerst aufwendige und deswegen auch sehr teure Analysegeräte verwendet. Für eine solche Analyse ist es erforderlich, den integrierten Schaltungsbaustein zu öffnen und für die Messungen zu präparieren. Durch diese Maßnahmen verändert sich aber das elektrische Verhalten der Schaltung und es ist teilweise nicht mehr möglich, Fehler zu reproduzieren.

Nicht zugängliche Schaltungsstellen können auch aufgrund der Definition und des Designs von integrierten Schaltungsbausteinen bedingt sein. Werden beispielsweise integrierte Schaltungen in den neuen, sogenannten BGA(Ball Grid Array)-Gehäusen und dann im System auf einer Systemplatte montiert, so sind am BGA-Gehäuse die Kontaktpunkte (Balls) zum Systemboard nicht mehr zugänglich, da sich die Kontaktpunkte auf der Unterseite des Gehäuses befinden und damit zwischen Gehäuse und Systemboard verschwinden. Somit sind die Signale an den Kontaktpunkten für Analyse- und Testzwecke nicht mehr abgreifbar. Bei Einsatz von TQPF-Gehäusen für integrierte Halbleiterschaltungen beispielsweise stellt sich dieses Problem nicht, da auch im System die Signale direkt an den Pins abgegriffen werden können.

Bei BGA-Gehäusen werden dagegen auf dem Systemboard die wichtigsten Signale auf Testpunkte geführt und von dort weiter zum angeschlossenen Chip. Dies kostet zum einen Platz auf dem jeweiligen Systemboard, was zwangsläufig mit zusätzlichen Kosten verbunden ist, und zum anderen zusätzlichen Aufwand bei der Entflechtung, bei der die entsprechenden Signale erst an die Oberfläche der teilweise mehrlagigen Leiterplatte geführt werden müssen. Aus diesen Gründen werden nur sehr wenige Signale auf Testpunkte geführt, was bedeutet, daß es im Fehlerfall durchaus möglich ist, daß gerade das gewünschte Signal nicht abgreifbar ist.

Aus der EP 0 650 069 A ist eine Einrichtung gemäß dem Oberbegriff des Anspruchs 1 bekannt. Eine solche Einrichtung löst einige, aber nicht alle Probleme, die bei der Vermessung und Analyse von elektrischen Signalen eines integrierten Schaltungsbausteins auftreten können.

Der Erfindung liegt die Aufgabe zugrunde, eine technisch wenig aufwendige Möglichkeit zu schaffen, um die an nicht zugänglichen Schaltungsstellen eines integrierten Schaltungsbausteins vorliegenden Signale, z.B. chipinterne Signale oder alle Signale an den Kontaktpunkten einer von einem BGA-Gehäuse eingeschlossenen integrierten Halbleiterschaltung, beobachten zu können, so daß Tests bzw. Analysen auch bei auffällig gewordenen Serienprodukten ohne weiteres durchgeführt werden können.

Diese Aufgabe wird erfindungsgemäß durch die in Anspruch 1 beanspruchte Einrichtung gelöst.

Hierdurch ist es möglich, an nicht zugänglichen Kontaktpunkten des Gehäuses eines integrierten Schaltungsbausteins anliegende Signale sichtbar zu machen und das zeitliche Verhalten genau zu bestimmen.

Bei einer vorteilhaften Weiterbildung der Erfindung wird an eine der externen Test-Anschlußkontaktstellen selektiv durchschaltbar ein Referenzsignal über einen bausteininternen Leitungsweg von einer extern nicht zugänglichen Schaltungsstelle herangeführt, und an eine andere Test-Anschlußkontaktstelle bzw. an die anderen Test-Anschlußkontaktstellen werden zu vermessende bzw. zu analysierende Signale jeweils selektiv durchschaltbar über bausteininterne Leitungswege von extern nicht zugänglichen Schaltungsstellen herangeführt. Für die Bestimmung des zeitlichen Signalverhaltens kann also zusätzlich zum zu analysierenden Signal ein Referenzsignal verfügbar gemacht werden. Um zeitgenaue Analysen von chipinternen Signalen wie z.B. von Taktsignalen und asynchronen Signalen zu ermöglichen, werden also mindestens zwei externe Test-Anschlußkontaktstellen vorgesehen.

Die nicht zugänglichen Signale können auch interne Chip-signale des integrierten Schaltungsbausteins umfassen.

Das Gehäuse des integrierten Schaltungsbausteins kann insbesondere ein sogenanntes BGA-Gehäuse (Ball Grid Array-Gehäuse) sein, bei dem die durch Kontaktpunkte (Balls) realisierten Test-Anschlußkontaktstellen nicht zugänglich sind, weil sich die Kontaktpunkte auf der Unterseite des Gehäuses befinden und damit zwischen dem Gehäuse und einem Systemboard, auf dem das Gehäuse angebracht ist, verschwinden, wobei die besonderen Kontaktpunkte, an welche die zu vermessenden und zu analysierenden Signale anderer Kontaktpunkte sowie die ebenfalls an anderen Kontaktpunkten vorliegenden Referenzsignale in selektiver Durchschaltung zugeleitet sind, mit entsprechend vielen metallischen Testpunkten auf dem Systemboard elektrisch leitend verbunden sind.

Bei Verwendung eines BGA-Gehäuses als Gehäuse des integrierten Schaltungsbausteins werden im BGA-Gehäuse ein oder mehrere Kontaktpunkte definiert, deren Signale auf dem kundenspezifischen Systemboard an Testpunkten sichtbar gemacht werden. Auf diese Kontaktpunkte können die Signale von allen anderen Kontaktpunkten des integrierten Schaltungsbausteins sichtbar gemacht werden.

Im integrierten Schaltungsbaustein ist in vorteilhafter Weise zur selektiven Durchschaltung eine zeitlich gesteuerte Multiplex-Schaltung vorgesehen, über welche die verschiedenen zu vermessenden bzw. zu analysierenden Signale und die jeweiligen Referenzsignale an die Test-Anschlußkontaktstellen durchgeschaltet werden. Ist die zeitlich gesteuerte Multiplex-Schaltung in einem von einem BGA-Gehäuse umschlossenen integrierten Schaltungsbaustein vorgesehen, so sind die nicht als Test-Anschlußkontaktstellen dienenden Kontaktpunkte elektrisch leitend mit Eingängen der Multiplex-Schaltung verbunden, deren Ausgänge mit den besonderen, die Test-Anschlußkontaktstellen bildenden Kontaktpunkten des BGA-Gehäuses elektrisch leitend verbunden sind. Es können dann alle Kontaktpunktsignale beliebig auf die bestimmten Test-Kontaktpunkte gemultiplext werden. Bislang war ein Signal immer eindeutig einem oder sehr wenigen Kontaktpunkten zugeordnet.

Eine vorteilhafte Weiterbildung der Einrichtung nach der Erfindung besteht darin, daß die die selektive Durchschaltung an die Test-Anschlußkontaktstellen vorgebende Steuerung der Multiplex-Schaltung programmierbar ausgebildet ist. Dadurch läßt sich die Multiplex-Schaltung auch während des Betriebes wie benötigt programmieren.

Eine entsprechend der Erfindung ausgebildete Einrichtung kann zur Analyse des integrierten Schaltungsbausteins mittels eines Bausteintesters, dem die an den Test-Anschlußkontaktstellen jeweils vorliegenden Signale zur Analyse eingegeben werden, verwendet werden.

Eine Einrichtung nach der Erfindung läßt sich auch zur direkten Analyse des integrierten Schaltungsbausteins in einer Applikation innerhalb eines Systems einsetzen, wobei die an den Test-Anschlußkontaktstellen vorliegenden Signale vermessen und analysiert werden. Dabei kann zusätzlich auch das System, in welchem der integrierte Schaltungsbaustein eingesetzt ist, analysiert werden.

Die Test-Anschlußkontaktstellen können vorteilhaft wahlweise auch in umgekehrter Betriebsrichtung zur Eingabe von Signalen an die extern unzugänglichen Schaltungsstellen des integrierten Schaltungsbausteins dienen (Eingabe-Mode).

Die Erfindung wird im folgenden anhand von in Zeichnungen dargestellten Ausführungsbeispielen erläutert. Es zeigen:
FIG. 1 die schematische Darstellung eines integrierten elektrischen Halbleiter-Schaltungsbausteins (Chip) mit zwei externen Test-Anschlußkontaktstellen (Pins), über die interne Chip-Signale beobachtet werden können,
FIG. 2 eine ebenfalls schematische Darstellung eines elektrischen Halbleiter-Chips mit zwei externen Test-Pads, über die Signale von im Einbau nicht zugänglichen anderen Pads eines BGA-Gehäuses beobachtet werden können,
FIG. 3 die schematische Ansicht von in einem BGA-Gehäuse montierten elektrischen Halbleiter-Chips in einem Gesamtsystem, und
FIG. 4a, 4b und 4c untereinander eine Ansicht von unten, von der Seite bzw. von oben eines BGA-Gehäuses (Plastic Thin Flat Ball Grid Array).

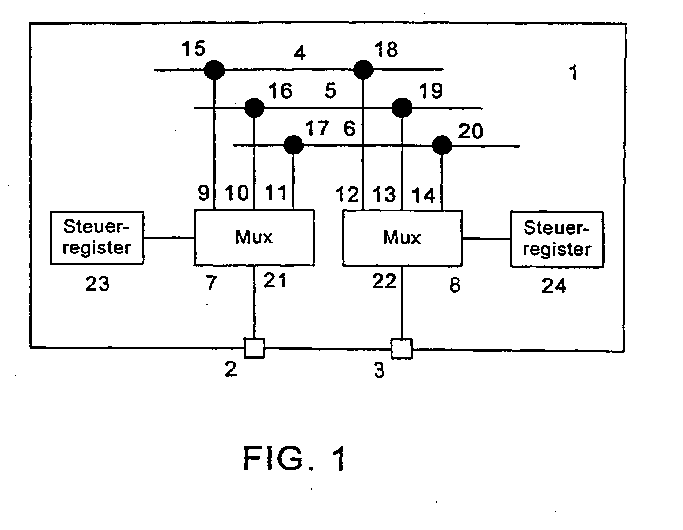

Der in der FIG. 1 schematisch abgebildete integrierte Halbleiter-Schaltungsbaustein (Chip) 1 weist zwei externe Test-Anschlußkontaktstellen (Pins) 2 und 3 auf, über die chipinterne Signale 4, 5 und 6 zeitgenau beobachtet werden können, also Signale, die an nicht ohne weiteres zugänglichen Stellen der Schaltung vorliegen. Es können z.B. Takte gegeneinander vermessen werden, asynchrone Signale wie Interrupts vermessen werden oder Funktionen in Abhängigkeit von asynchronen Signalen analysiert werden. Zwei externe Anschlußkontaktstellen 2 und 3 weist der integrierte Schaltungsbaustein 1 deswegen auf, weil das zeitliche Verhalten genau bestimmt werden soll.

Für eine solche Bestimmung ist zusätzlich zum zu analysierenden Signal an einer der Test-Anschlußkontaktstellen 2 bzw. 3 ein Referenzsignal an der jeweils anderen Test- Anschlußkontaktstelle verfügbar. Daraus folgt, daß zur zeitgenauen Analyse von chipinternen Signalen 4, 5 oder 6 mindestens zwei Test-Anschlußkontaktstellen 2 und 3 vorhanden sein müssen. Zur selektiven Durchschaltung der internen Chipsignale 4, 5 oder 6 sind als Multiplex-Schaltung zwei Multiplexer 7 und 8 vorgesehen, deren Eingänge 9, 10, 11 bzw. 12, 13, 14 mit den signalführenden chipinternen Stellen 15, 16, 17 bzw. 18, 19, 20 verbunden sind. Die Ausgänge 21 und 22 der beiden Multiplexer 7 bzw. 8 sind mit den beiden externen Test-Anschlußkontaktstellen (Pins) 2 bzw. 3 elektrisch verbunden.

Gesteuert wird die Durchschaltung der beiden Multiplexer 7 und 8, die z.B. als Logik oder Tristate realisiert werden können, von jeweils einem Steuerregister 23 bzw. 24, die über einen Controller, einen digitalen Signalprozessor oder einen Tapcontroller während des Betriebs programmierbar sind.

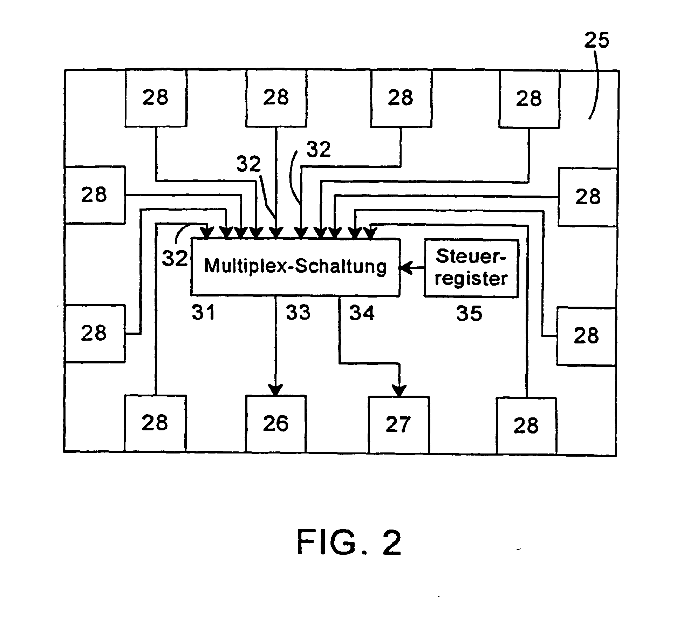

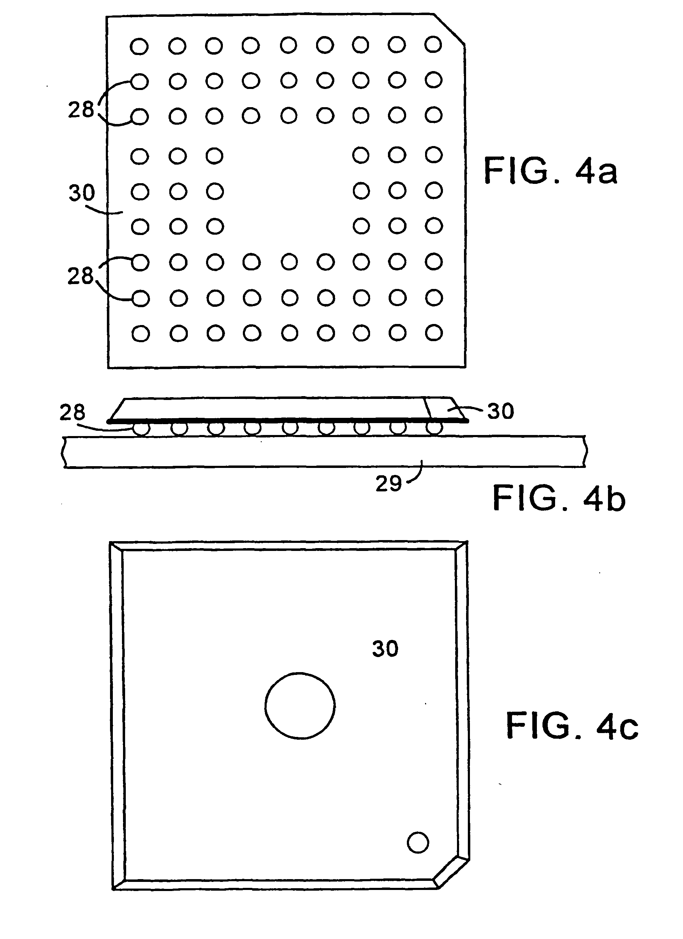

In der FIG. 2 ist ebenfalls schematisch ein integrierter elektrischer Halbleiter-Schaltungsbaustein (Chip) 25 mit zwei externe Test-Anschlußkontaktstellen bildenden Test-Kontaktpunkten (Test-Pads; Test-Balls) 26 und 27 dargestellt, über die Signale von im Einbau nicht zugänglichen anderen Kontaktpunkten (Pads; Balls) 28 eines BGA-Gehäuses beobachtet werden können. Wie FIG. 4a, 4b und 4c in drei verschiedenen Ansichten zeigen, sind die Kontaktpunkte 28 zum Systemboard 29 nicht zugänglich, da sich die Kontaktpunkte 28 auf der Unterseite des Gehäuses 30 befinden und damit zwischen dem Gehäuse 30 und dem Systemboard 29 verschwinden.

Somit sind die Signale an den Kontaktpunkten 28 für Test- und Analysezwecke nicht abgreifbar. Zur selektiven Durchschaltung der an den Kontaktpunkten 28 vorliegenden Signale ist entsprechend der FIG. 2 eine Multiplex-Schaltung 31 vorgesehen, deren Eingänge 32 mit den einzelnen Kontaktpunkten 28 verbunden sind.

Die Ausgänge 33 und 34 der Multiplex-Schaltung 31 sind mit den beiden externen Test-Kontaktpunkten (Test-Balls) 26 bzw. 27 elektrisch verbunden. Gesteuert wird die Durchschaltung der Multiplex-Schaltung 31, die z.B. als Logik oder Tristate realisiert werden kann, von einem Steuerregister 35, das über einen Controller, einen digitalen Signalprozessor oder einen Tapcontroller während des Betriebs programmierbar ist.

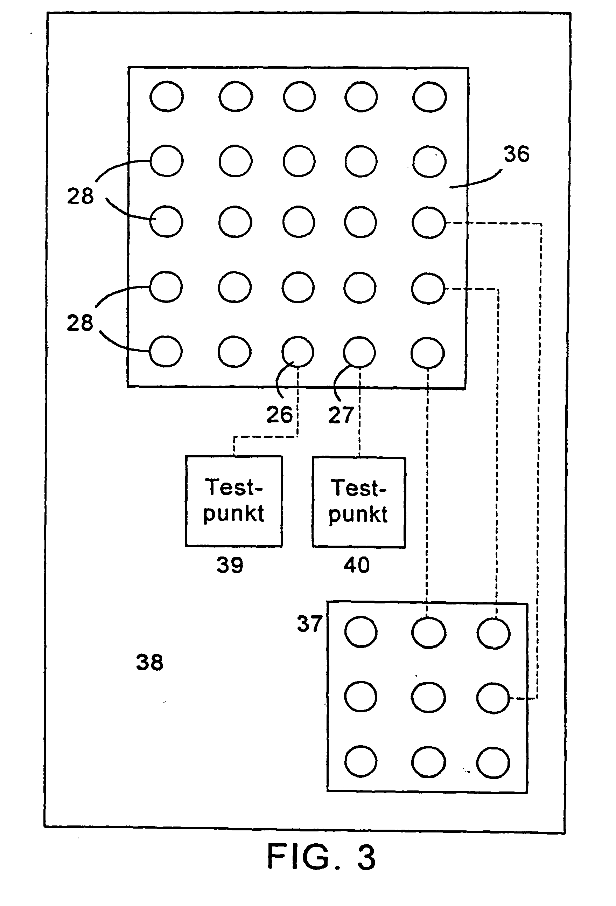

In der FIG. 3 ist eine schematische Ansicht von jeweils in einem BGA-Gehäuse montierten integrierten Halbleiter-Schaltungsbausteinen 36 und 37 in einem Gesamtsystem dargestellt, das auf einem kundenspezifischen Systemboard 38 aufgebaut ist. Auf dem Systemboard 38 sind zwei metallische Testpunkte 39 und 40 aufgebracht, die mit den beiden Test-Kontaktpunkten 26 und 27 elektrisch verbunden sind. Die Signale der beiden als Test-Kontaktpunkte 26 und 27 definierten Balls des integrierten Halbleiter-Schaltungsbausteins 36 werden auf dem Systemboard 38 an den beiden Testpunkten 39 und 40 sichtbar gemacht.

Auf diese beiden Kontaktpunkte 26 und 27 und somit auf die Testpunkte 39 und 40 können die Signale von allen anderen Kontaktpunkten 28 des integrierten Schaltungsbausteins 36 sichtbar gemacht werden. Die gesteuerte selektive Durchschaltung der einzelnen Signale von allen Kontaktpunkten 28 zu den Test-Kontaktpunkten 26 bzw. 27 erfolgt entsprechend FIG. 1 mittels der Multiplex-Schaltung 31.

Bezugszeichenliste
- 1: Integrierter Schaltungsbaustein (Chip)
- 2, 3: Test-Anschlußkontaktstellen (Test-Pins)
- 4, 5, 6: Chipinterne Signale
- 7, 8: Multiplexer
- 9 bis 14: Eingänge
- 15 bis 20: Chipinterne Schaltungsstellen
- 21, 22: Ausgänge
- 23, 24: Steuerregister
- 25: Integrierter Schaltungsbaustein (Chip)
- 26, 27: Test-Anschlußkontaktstellen (Test-Pads; Test-Balls)
- 28: Anschlußkontaktstellen, Kontaktpunkte (Pads, Balls)
- 29: Systemboard
- 30: Gehäuse
- 31: Multiplex-Schaltung
- 32: Eingänge
- 33, 34: Ausgänge
- 35: Steuerregister
- 36, 37: Integrierte Schaltungsbausteine (Chips)
- 38: Systemboard
- 39, 40: Testpunkte

## Patentansprüche

1. Einrichtung zur elektrischen Vermessung und Analyse von an extern nicht zugänglichen Schaltungsstellen vorliegenden elektrischen Signalen eines integrierten, mit einer Vielzahl von Anschlußkontaktstellen (Pads; Pins; Balls) versehenen Schaltungsbausteins (IC; Integrated Circuit; Chip), wobei am integrierten Schaltungsbaustein (1) eine oder mehrere externe Test-Anschlußkontaktstellen (2, 3) vorgesehen sind, an die zu vermessende bzw. zu analysierende Signale (4, 5, 6) jeweils selektiv durchschaltbar über bausteininterne Leitungswege von den extern nicht zugänglichen Schaltungsstellen (15 bis 20) herangeführt sind,
**dadurch gekennzeichnet,**
**daß** die nicht zugänglichen Signale solche Signale sind, die an nicht zugänglichen Kontaktpunkten (28) des Gehäuses eines integrierten Schaltungsbausteins (25) vorliegen.

2. Einrichtung nach Anspruch 1,
**dadurch gekennzeichnet,**
**daß** an eine (2) der externen Test-Anschlußkontaktstellen (2, 3) selektiv durchschaltbar ein Referenzsignal über einen bausteininternen Leitungsweg von einer extern nicht zugänglichen Schaltungsstelle (15 bis 17) herangeführt ist und daß an die andere Test-Anschlußkontaktstelle (3) bzw. an die anderen Test-Anschlußkontaktstellen zu vermessende bzw. zu analysierende Signale jeweils selektiv durchschaltbar über bausteininterne Leitungswege von extern nicht zugänglichen Schaltungsstellen (18 bis 20) herangeführt sind.

3. Einrichtung nach Anspruch 2,
**dadurch gekennzeichnet,**
**daß** nur zwei externe Test-Anschlußkontaktstellen (2, 3) vorgesehen sind.

4. Einrichtung nach einem der vorhergehenden Ansprüche,
**dadurch gekennzeichnet,**
**daß** die nicht zugänglichen Signale (4, 5, 6) interne Chip-signale des integrierten Schaltungsbausteins (1) sind, der so ausgelegt ist, daß diese Signale einschließlich von Referenzsignalen selektiv durchschaltbar an die Test-Anschlußkontaktstellen (2, 3) geleitet sind.

5. Einrichtung nach einem der vorhergehenden Ansprüche,
**dadurch gekennzeichnet,**
**daß** das Gehäuse des integrierten Schaltungsbausteins ein sogenanntes BGA-Gehäuse (Ball Grid Array-Gehäuse) ist, bei dem die durch Kontaktpunkte (Balls) realisierten Test-Anschlußkontaktstellen (28) nicht zugänglich sind, weil sich die Kontaktpunkte auf der Unterseite des BGA-Gehäuses (30) befinden und damit zwischen dem Gehäuse und einem Systemboard (29, 38), auf dem das Gehäuse angebracht ist, verschwinden und daß die besonderen Kontaktpunkte (26, 27), an welche die zu vermessenden und zu analysierenden Signale anderer Kontaktpunkte sowie die ebenfalls an anderen Kontaktpunkten vorliegenden Referenzsignale in selektiver Durchschaltung zugeleitet sind, mit entsprechend vielen metallischen Testpunkten (39, 40) auf dem Systemboard (29, 38) elektrisch leitend verbunden sind.

6. Einrichtung nach einem der vorhergehenden Ansprüche,
**dadurch gekennzeichnet,**
**daß** im integrierten Schaltungsbaustein (1; 25) zur selektiven Durchschaltung eine zeitlich gesteuerte Multiplex-Schaltung (7, 8; 31) vorgesehen ist, über welche die verschiedenen zu vermessenden und zu analysierenden Signale und gegebenenfalls die jeweiligen Referenzsignale an die externen Test-Anschlußkontaktstellen (2, 3; 26, 27) durchgeschaltet werden.

7. Einrichtung nach Anspruch 6,
**dadurch gekennzeichnet,**
**daß** die zeitlich gesteuerte Multiplex-Schaltung (31) in dem vom BGA-Gehäuse umschlossenen integrierten Schaltungsbaustein (25) vorgesehen ist und daß die nicht als externe Test-Anschlußkontaktstellen (28) dienenden Kontaktpunkte elektrisch leitend mit Eingängen (32) der Multiplex-Schaltung (31) verbunden sind, deren Ausgänge (33, 34) mit den besonderen, die externen Test-Anschlußkontaktstellen (26, 27) bildenden Kontaktpunkten des BGA-Gehäuses elektrisch leitend verbunden sind.

8. Einrichtung nach Anspruch 6 oder 7,
**dadurch gekennzeichnet,**
**daß** die die selektive Durchschaltung an die externen Test-Anschlußkontaktstellen (2, 3; 26, 27) vorgebende Steuerung der Multiplex-Schaltung (7, 8; 31) programmierbar ausgebildet ist.

9. Einrichtung nach einem der vorhergehenden Ansprüche,
**dadurch gekennzeichnet,**
**daß** die Test-Anschlußkontaktstellen (2, 3) wahlweise in umgekehrter Betriebsrichtung zur Eingabe von Signalen an die extern nicht zugänglichen Schaltungsstellen (15 bis 20) des integrierten Schaltungsbausteins (1) dienen (Eingabe-Mode).

10. Einrichtung nach einem der vorhergehenden Ansprüche,
**gekennzeichnet durch**
eine Verwendung zur Analyse des integrierten Schaltungsbausteins (1) mittels eines Bausteintesters, dem die an den Test-Anschlußkontaktstellen (2, 3) jeweils vorliegenden Signale zur Analyse eingegeben werden.

11. Einrichtung nach einem der Ansprüche 1 bis 9,
**gekennzeichnet durch**
eine Verwendung zur Analyse des integrierten Schaltungsbausteins (1) in einer Applikation innerhalb eines Systems, wobei die an den Test-Anschlußkontaktstellen (2, 3) vorliegenden Signale vermessen und analysiert werden.

12. Einrichtung nach Anspruch 11,
**gekennzeichnet durch**
eine zusätzliche Verwendung zur Analyse des Systems, in welchem der integrierte Schaltungsbaustein (1) eingesetzt ist.

## Claims

1. Device for electrical measurement and analysis of electrical signals which are present at circuit points that are not externally accessible in an integrated circuit component (IC; integrated circuit; chip) which is provided with a large number of connecting contact points (pads; pins; balls), the integrated circuit component (1) being provided with one or more external test connecting contact points (2, 3) to which signals (4, 5, 6) which are to be measured or are to be analyzed are in each case selectively applied such that they can be passed on via routes within the component from the circuit points (15 to 20) which are not externally accessible, **characterized in that** the inaccessible signals are signals which are present inaccessible contact points (28) on the package of an integrated circuit component (25).

2. Device according to Claim 1,
**characterized in that** a reference signal is selectively applied such that it can be passed on via a route within the component to one (2) of the external test connecting contact points (2, 3) from a circuit point (15 to 17) which is not externally accessible, and **in that** signals which are to be measured or are to be analyzed are in each case selectively applied such that they can be passed on via routes within the component to the other test connecting contact point(s) (3) from circuit points (18 to 20) which are not externally accessible.

3. Device according to Claim 2,
**characterized in that** only two external test connecting contact points (2, 3) are provided.

4. Device according to one of the preceding claims,
**characterized in that** the signals (4, 5, 6) which are not accessible are internal chip signals in the integrated circuit component (1), which is designed such that these signals, including reference signals, can be selectively passed on to the test connecting contact points (2, 3).

5. Device according to one of the preceding claims,
**characterized in that** the package of the integrated circuit component is a so-called BGA package (ball grid array package), in which the test connecting contact points (28), which are provided by contact points (balls), are inaccessible since the contact points are located on the lower face of the BGA package (30) and are thus concealed between the package and a system board (29, 38) on which the package is fitted, and **in that** the particular contact points (26, 27) to which those signals which are to be measured and are to be analyzed from other contact points are supplied and to which those reference signals which are likewise present at other contact points are supplied such that they are passed on selectively, are electrically conductively connected to a corresponding number of metallic test points (39, 40) on the system board (29, 38).

6. Device according to one of the preceding claims,
**characterized in that** a time-controlled multiplexing circuit (7, 8; 31) is provided for passing on signals selectively in the integrated circuit component (1; 25), via which multiplexing circuit (7, 8; 31) the various signals which are to be measured and are to be analyzed and, if appropriate, the respective reference signals, are passed on to the external test connecting contact points (2, 3; 26, 27).

7. Device according to Claim 6,
**characterized in that** the time-controlled multiplexing circuit (31) is provided in the integrated circuit component (25) which is surrounded by the BGA package, and **in that** those contact points which are not used as external test connecting contact points (28) are electrically conductively connected to inputs (32) of the multiplexing circuit (31), whose outputs (33, 34) are electrically conductively connected to those particular contact points in the BGA package which form the external test connecting contact points (26, 27).

8. Device according to Claim 6 or 7,
**characterized in that** the control of the multiplexing circuit (7, 8; 31), which predetermines the selective passing on of signals to the external test connecting contact points (2, 3; 26, 27), is programmable.

9. Device according to one of the preceding claims,
**characterized in that** the test connecting contact points (2, 3) are selectively used in the opposite operating direction for inputting signals to those circuit points (15 to 20) which are not externally accessible in the integrated circuit component (1) (input mode).

10. Device according to one of the preceding claims,
**characterized by** use for analysis of the integrated circuit component (1) by means of a component tester, to which those signals which are respectively present at the test connecting contact points (2, 3) are applied for analysis.

11. Device according to one of Claims 1 to 9,
**characterized by** use for analysis of the integrated circuit component (1) in an application within a system, in which the signals which are present at the test connecting contact points (2, 3) are measured and analyzed.

12. Device according to Claim 11,
**characterized by** additional use for analysis of the system in which the integrated circuit component (1) is used.

## Revendications

1. Dispositif de mesure électrique et d'analyse de signaux électriques appliqués sur des emplacements d'un circuit non accessibles de l'extérieur d'un module de circuit (IC; circuit intégré, puce) doté de plusieurs points de contact de raccordement (tampons, pattes, billes),
le module (1) de circuit intégré présentant un ou plusieurs emplacements externes de contact de raccordement de test (2, 3) sur lesquels les signaux (4, 5, 6) à mesurer ou à analyser peuvent être amenés depuis les emplacements de circuit (15 à 20) non accessibles à l'extérieur par connexion sélective et par l'intermédiaire de pistes conductrices internes du module,
**caractérisé en ce que**
les signaux non accessibles sont les signaux qui sont appliqués sur des points de contact (28) non accessibles de l'extérieur du boîtier d'un module de circuit intégré (25).

2. Dispositif selon la revendication 1, **caractérisé en ce qu'**un signal de référence apte à être appliqué sélectivement est amené par une piste conductrice interne du module depuis un emplacement de circuit (15 à 17) non accessible de l'extérieur jusqu'à un (2) des emplacements externes de contact de raccordement de test (2, 3) et **en ce que** des signaux à mesurer ou à analyser qui peuvent être appliqués chacun sélectivement sont amenés par des pistes conductrices internes du module depuis des emplacements (18 à 20) du circuit non accessibles de l'extérieur jusqu'à l'autre emplacement de contact de raccordement de test (3) ou jusqu'aux autres emplacements de contact de raccordement de test.

3. Dispositif selon la revendication 2, **caractérisé en ce qu'**il ne présente que deux emplacements externes de contact de raccordement de test (2, 3).

4. Dispositif selon l'une des revendications précédentes, **caractérisé en ce que** les signaux non accessibles (4, 5, 6) sont des signaux de la puce du module de circuit intégré (1) qui est conçu de telle sorte que ces signaux, y compris des signaux de référence, sont amenés par connexion sélective aux emplacements de raccordement de contact de test (2, 3).

5. Dispositif selon l'une des revendications précédentes, **caractérisé en ce que** le boîtier du module de circuit intégré est un boîtier dit BGA ("Ball Grid Array") dans lequel les emplacements de contact de raccordement de test (28) configurés comme points de contact (billes) ne sont pas accessibles parce que les points de contact sont situés sur le côté inférieur du boîtier BGA (30) et qu'ils disparaissent ainsi entre le boîtier et une carte système (29, 38) sur laquelle le boîtier est placée et **en ce que** les points de contact particuliers (26, 27) sur lesquels les signaux à mesurer et à analyser en d'autres points de contact ainsi que les signaux de référence éventuellement appliqués sur d'autres points de contact sont amenés par connexion sélective sont reliés de manière électriquement conductrice à un nombre correspondant de points métalliques de test (39, 40) prévus sur la carte système (29, 38).

6. Dispositif selon l'une des revendications précédentes, **caractérisé en ce qu'**un circuit de multiplexage (7, 8; 31) commandé temporellement et par lequel les différents signaux à mesurer et à analyser et éventuellement les signaux de référence concernés sont amenés aux emplacements externes de contact de raccordement de test (2, 3; 26, 27) est prévu dans le module intégré de circuit (1; 25) pour la connexion sélective.

7. Dispositif selon la revendication 6, **caractérisé en ce que** le circuit de multiplexage (31) à commande temporelle est prévu dans le module de circuit intégré (25) entouré par le boîtier BGA et **en ce que** les points de contact qui ne servent pas d'emplacements externes de contact de raccordement de test (28) sont reliés de manière électriquement conductrice à des entrées (32) du circuit de multiplexage (31) dont les sorties (33, 34) sont reliées de manière électriquement conductrice aux points de contact particuliers du boîtier BGA qui forment les emplacements externes de contact de raccordement de test (26, 27).

8. Dispositif selon les revendications 6 ou 7, **caractérisé en ce que** la commande du circuit de multiplexage (7, 8; 31) qui définit la connexion sélective avec les emplacements externes de contact de raccordement de test (2, 3; 26, 27) est programmable.

9. Dispositif selon l'une des revendications précédentes, **caractérisé en ce que** dans un mode de fonctionnement inverse, les emplacements de contact de raccordement de test (2, 3) servent à appliquer sélectivement des signaux sur les emplacements de circuit (15 à 20) non accessibles de l'extérieur du module de circuit intégré (1) (mode d'introduction).

10. Dispositif selon l'une des revendications précédentes, **caractérisé en ce qu'**il est utilisé pour l'analyse du module de circuit intégré (1) au moyen d'un testeur de module dans lequel les signaux appliqués sur les emplacements de contact de raccordement de test (2, 3) sont introduits pour analyse.

11. Dispositif selon l'une des revendications 1 à 9, **caractérisé en ce qu'**il est utilisé pour l'analyse du module de circuit intégré (1) dans une application interne à un système, les signaux appliqués sur les emplacements de contact de raccordement de test (2, 3) étant mesurés et analysés.

12. Dispositif selon la revendication 11, **caractérisé en ce qu'**il est en outre utilisé pour l'analyse du système dans lequel le module de circuit intégré (1) est utilisé.
